# EUROPEAN PATENT APPLICATION

(11) **EP 4 697 552 A1**
(43) Date of publication of application: **18.02.2026**
(21) Application number: 24907701.7
(22) Date of filing: 30.09.2024
(51) Int. Cl.: H02J 7/00, G01R 31/382, H01M 10/42, H01M 10/44

(54) **BATTERY MANAGEMENT DEVICE AND BATTERY BALANCING METHOD THEREBY**

(30) Priority: 21.12.2023 KR 20230188254
(71) Applicant: LG Energy Solution, Ltd., Seoul 07335 (KR)
(72) Inventor: JANG, Kiwook, Daejeon 34122 (KR); KIM, Duksu, Daejeon 34122 (KR); PARK, Jongdoo, Daejeon 34122 (KR); AN, Jinhyuk, Daejeon 34122 (KR); LIM, Geunwook, Daejeon 34122 (KR)
(74) Representative: BCKIP Part mbB
(86) International application number: PCT/KR2024/014871
(87) International publication number: WO 2025/135416

(57) **Abstract**

Disclosed is a battery management apparatus, located in a battery system including a plurality of batteries, which include at least one processor; and a memory configured to store at least one instruction executed by the at least one processor.

Here, the at least one instruction may include an instruction to collect state information including charge state values of the batteries; an instruction to determine whether a charge state value of at least one of the batteries falls within a predetermined low charge state range or a high charge state range; an instruction to determine whether a balancing initiation condition defined in correspondence with a current charge state range is satisfied based on the state information of the batteries; and an instruction to determine whether to initiate a balancing mode for balancing the batteries based on the determination result.

## Description

### [Technical Field]

This application claims priority to and the benefit of Korean Patent Application No.10-2023-0188254 filed in the Korean Intellectual Property Office on December 21, 2023, the entire contents of which are incorporated herein by reference.

The present invention relates to a battery management apparatus and a battery balancing method thereof, and more particularly, to a battery system and a battery balancing method thereof, for balancing a battery having a voltage plateau in a charge characteristic curve.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells is connected in series and parallel or a battery pack in which battery modules are connected in series and parallel according to system requirements. For medium and large-sized devices such as automobiles, a high-capacity battery system with multiple battery racks connected in parallel may be applied to satisfy required capacity of the device.

Carbon materials are mainly used as an anode active material of lithium secondary batteries, and lithium-containing cobalt oxide (LiCoO2) is mainly used as a cathode active material. In addition, lithium-containing manganese oxides (LiMnO2, LiMn2O4, etc.) and lithium-containing nickel oxide (LiNiO2) are also being considered.

Recently, a lithium iron phosphate (LiFePO4)-based compound has been used as a cathode active material for a lithium secondary battery. A lithium iron phosphate (LFP) battery using lithium iron phosphate as a cathode active material is superior in terms of thermal stability and cost efficiency compared to other types of batteries. However, the LFP battery shows a flat characteristic with a voltage plateau in a charge characteristic curve (a relationship curve between open circuit voltage and SOC), and a problem arises due to this that SOC (State Of Charge) cannot be accurately estimated in the plateau section.

In order to resolve imbalances among battery cells during operation of a battery system, cell balancing control based on an estimated SOC value is essential. However, in the case of the LFP battery, it is difficult to accurately estimate SOC in the plateau section, and thus, cell balancing control is performed only in non-flat sections (e.g., a section where the SOC is 90% or more).

Accordingly, an appropriate control technique for balancing a battery having a voltage plateau in a charge characteristic curve, such as the LFP battery, is needed.

### [Detailed Description of the Invention]

### [Technical Problem]

To obviate one or more problems of the related art, embodiments of the present disclosure provide a battery management apparatus for balancing a battery having a voltage plateau in a charge characteristic curve.

To obviate one or more problems of the related art, embodiments of the present disclosure also provide a battery balancing method by the battery management apparatus.

To obviate one or more problems of the related art, embodiments of the present disclosure also provide a battery system including the battery management apparatus.

### [Technical Solution]

In order to achieve the objective of the present disclosure, a battery management apparatus, located in a battery system including a plurality of batteries, may include at least one processor; and a memory configured to store at least one instruction executed by the at least one processor.

Here, the at least one instruction may include an instruction to collect state information including charge state values of the batteries; an instruction to determine whether a charge state value of at least one of the batteries falls within a predetermined low charge state range or a high charge state range; an instruction to determine whether a balancing initiation condition defined in correspondence with a current charge state range is satisfied based on the state information of the batteries; and an instruction to determine whether to initiate a balancing mode for balancing the batteries based on the determination result.

The low charge state range may be defined as a range lower than or equal to a predetermined first charge state value, and the high charge state range is defined as a range higher than or equal to a predetermined second charge state value.

The balancing initiation condition in the low charge state range may include at least one of a first condition in which the deviation among SOHs (State of Health) of the batteries is within a predetermined threshold range, a second condition in which temperature of the batteries is higher than or equal to a predetermined threshold temperature, and a third condition in which an idle period of the batteries exceeds a predetermined first period.

The balancing initiation condition in the high charge state range may include at least one of a second condition in which the temperature of the batteries is higher than or equal to a predetermined threshold temperature and a fourth condition in which an idle period of the batteries exceeds a predetermined second period.

The at least one instruction may further include an instruction to determining balancing target battery based on the difference between the charge state values of the batteries, if the balancing mode is initiated; and an instruction to perform a predetermined balancing control on the balancing target battery.

The instruction to determine the balancing target battery may include an instruction to, when the balancing mode is initiated in the low charge state range, determine at least one battery having a charge state value whose difference from the minimum charge state value is equal to or greater than a predetermined first threshold value as the balancing target battery; and an instruction to, when the balancing mode is initiated in the high charge state range, determine at least one battery having a charge state value whose difference from the minimum charge state value is equal to or greater than a predetermined second threshold value as the balancing target battery,

Here, the first threshold value may be determined to a value greater than the second threshold value.

The instruction to perform the predetermined balancing control may include an instruction to calculate a balancing period based on capacity of the balancing target battery; and an instruction to perform balancing control during the balancing period.

The instruction to perform the predetermined balancing control may include an instruction to monitor whether a charge state value of one or more of the batteries, during process of performing the balancing control, enters the high charge state range.

The instruction to perform the predetermined balancing control may include an instruction to re-determine balancing target battery if the charge state value of one or more of the batteries enters the high charge state range and the balancing initiation condition in the high charge state range is satisfied.

The instruction to perform the predetermined balancing control may include an instruction to monitor whether the charge state value of one or more of the batteries decreases below or equal to a predetermined third charge state value during a process of performing the balancing control; and an instruction to terminate the balancing control if the charge state value of one or more of the batteries decreases below or equal to the third charge state value.

According to another embodiment of the present disclosure, a battery balancing method, to be performed by a battery management apparatus for managing plurality of batteries, may include collecting state information including charge state values of the batteries; determining whether a charge state value of at least one of the batteries falls within a predetermined low charge state range or a high charge state range; determining whether a balancing initiation condition defined in correspondence with a current charge state range is satisfied based on the state information of the batteries; and determining whether to initiate a balancing mode for balancing the batteries based on the determination result.

The low charge state range may be defined as a range lower than or equal to a predetermined first charge state value, and wherein the high charge state range is defined as a range higher than or equal to a predetermined second charge state value.

The balancing initiation condition in the low charge state range may include at least one of a first condition in which the deviation among SOHs (State of Health) of the batteries is within a predetermined threshold range, a second condition in which temperature of the batteries is higher than or equal to a predetermined threshold temperature, and a third condition in which an idle period of the batteries exceeds a predetermined first period.

The balancing initiation condition in the high charge state range may include at least one of a second condition in which the temperature of the batteries is higher than or equal to a predetermined threshold temperature and a fourth condition in which an idle period of the batteries exceeds a predetermined second period.

The method may further include determining balancing target battery based on the difference between the charge state values of the batteries, if the balancing mode is initiated; and performing a predetermined balancing control on the balancing target battery.

The determining the balancing target battery may include, when the balancing mode is initiated in the low charge state range, determining at least one battery having a charge state value whose difference from the minimum charge state value is equal to or greater than a predetermined first threshold value as the balancing target battery; and, when the balancing mode is initiated in the high charge state range, determining at least one battery having a charge state value whose difference from the minimum charge state value is equal to or greater than a predetermined second threshold value as the balancing target battery.

Here, the first threshold value is determined to a value greater than the second threshold value.

The performing the predetermined balancing control may include calculating a balancing period based on capacity of the balancing target battery; and performing balancing control during the balancing period.

The performing the predetermined balancing control may include monitoring whether a charge state value of one or more of the batteries, during process of performing the balancing control, enters the high charge state range.

The performing the predetermined balancing control may include re-determining balancing target battery if the charge state value of one or more of the batteries enters the high charge state range and the balancing initiation condition in the high charge state range is satisfied.

The performing the predetermined balancing control may include monitoring whether the charge state value of one or more of the batteries decreases below or equal to a predetermined third charge state value during a process of performing the balancing control; and terminating the balancing control if the charge state value of one or more of the batteries decreases below or equal to the third charge state value.

According to another embodiment of the present disclosure, a battery system may include a plurality of batteries; and a battery management apparatus configured to collect state information of the batteries and to manage and control the batteries based on the collected state information.

Here, the battery management apparatus may be configured to determine whether a charge state value of at least one of the batteries falls within a predetermined low charge state range or a high charge state range, to determine whether a balancing initiation condition defined in correspondence with a current charge state range is satisfied based on the state information of the batteries, and to determine whether to initiate a balancing mode for balancing the batteries based on the determination result.

### [Advantageous Effects]

According to embodiments of the present disclosure, balancing control, more balancing control is performed for batteries having flat characteristics, so that the charge state of the batteries can be maintained more uniformly, and the capacity of the battery system can be utilized to the maximum.

### [Brief Description of the Drawings]

FIG. 1 shows a charge characteristic curve of an LFP battery.
FIG. 2 is a block diagram illustrating a battery system according to the present invention.
FIG. 3 is an operational flowchart of a battery balancing method according to embodiments of the present invention.
FIG. 4 is an operational flowchart of a battery balancing method after the initiation of the balancing mode according to embodiments of the present invention.
FIGS. 5 and 6 are operational flowcharts of a battery balancing method according to another embodiment of the present invention.
FIG. 7 is a block diagram of a battery management apparatus according to embodiments of the present invention.

10: battery
100: battery assembly
200, 700: battery management apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it may be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells are electrically connected.

A battery rack refers to a system of a single structure which is assembled by connecting module units set by a battery manufacturer in series/parallel and may be monitored and controlled by a battery management apparatus/system (BMS). A battery rack may include several battery modules and a battery protection unit or any other protection device. Here, the battery module may also be referred to as a battery pack depending on a device or system in which the battery is used.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

State of Charge (SOC) refers to a current state of charge of a battery, represented in percent points [%], and State of Health (SOH) may be a current condition of a battery compared to its ideal or original conditions, represented in percent points [%].

Nominal capacity (Nominal Capa.) refers to a capacity [Ah] of a battery which is set by a battery manufacturer during development of the battery.

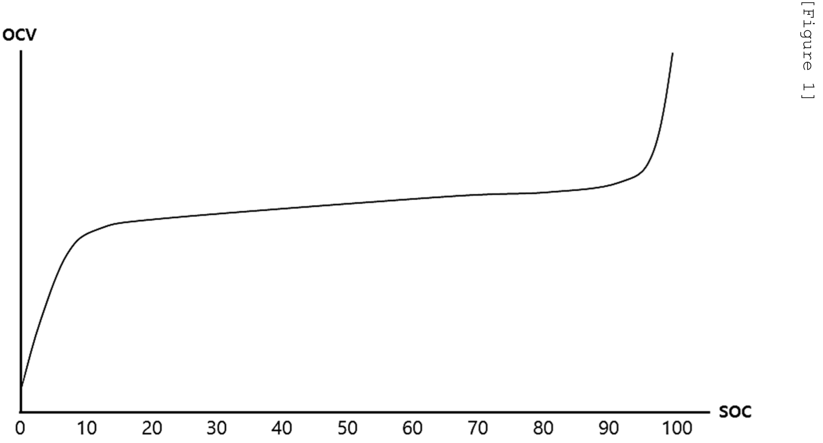

FIG. 1 shows a charge characteristic curve of an LFP battery.

More specifically, FIG. 1 shows a charge characteristic curve of a lithium iron phosphate (LFP) battery in which lithium iron phosphate is used as a cathode active material. The charge characteristic curve represents a correspondence between an open circuit voltage (OCV) and a SOC measured during a battery charging process.

In order to resolve imbalance between battery cells during operation of the battery system, the battery management system may compare SOCs of the battery cells to determine an imbalance state and, upon the imbalance state exceeding a predefined threshold level, balancing control may be performed. Here, a method of measuring an open-circuit voltage value of the battery and estimating an SOC of the battery based on the measured open-circuit voltage value is mainly used, in order to determine imbalance between battery cells.

Referring to FIG. 1, the charge characteristic curve of the LFP battery has a voltage plateau in the SOC range of about 10% to about 90%. In the case of an LFP battery having such a plateau characteristic, it is difficult to accurately estimate the SOC in the plateau section, so balancing control needs to be performed in a non-flat section.

When performing balancing on an LFP battery in a low SOC range (for example, a section where the SOC is 10% or less), it is difficult to accurately select a battery (a battery to be balanced) that is in an unbalanced state and the voltage of the battery may decrease rapidly due to balancing control, which may cause over-discharge.

Accordingly, in a battery system to which LFP batteries are applied, balancing control is generally performed in a high SOC section (for example, a section where the SOC is 90% or more). However, in the case of a battery system linked to a PV (Photovoltaic) system, there are many cases where the full charge state (high SOC section) is not reached due to weather influence, so frequency of performing balancing control is low, and thus, the unbalanced state among batteries may not be resolved and a state deviation among the batteries may occur.

The present invention is presented to solve this problem and, hereinafter, preferred embodiments according to the present invention will be described in detail with reference to the accompanying drawings.

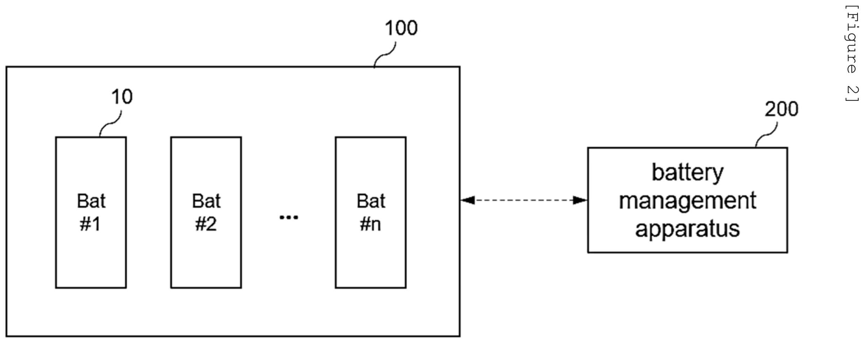

FIG. 2 is a block diagram illustrating a battery system according to the present invention.

Referring to FIG. 2, the battery system includes a battery assembly 100 including a plurality of batteries 10 and a battery management apparatus 200.

The plurality of batteries 10 may be electrically connected to each other to form a battery assembly.

The battery 10 may refert to a battery cell, a battery module, or a battery rack.

The battery 10 may correspond to an LFP battery cell or correspond to a battery module or a battery rack including a plurality of LFP batteries, but the scope of the present invention is not limited to this. In other words, the battery according to the present invention may correspond to a battery having at least a part of voltage plateau section in a charge characteristic curve.

The battery management apparatus 200 may manage and control the battery assembly 100 by collecting state information on the plurality of batteries 10 and performing a predefined control operation based on the collected state information. Here, the battery management apparatus 200 may control charging and discharging of batteries, diagnose whether batteries are out of order, and determine an imbalanced state of batteries to perform balancing control.

The battery management apparatus 200 may correspond to a battery management system (BMS) located within a battery system, or may be implemented as included in the BMS.

The battery system according to embodiments of the present invention may be implemented by being included in an energy storage system (ESS), but the scope of the present invention is not limited thereto. In other words, the battery system according to the present invention may be applied to various devices such as electric vehicles.

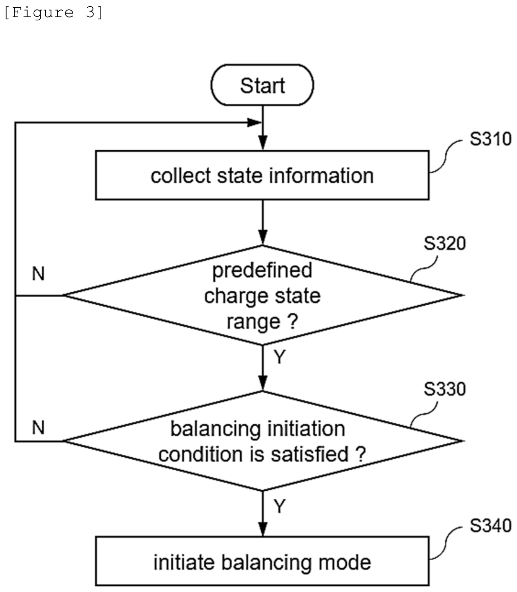

FIG. 3 is an operational flowchart of a battery balancing method according to embodiments of the present invention.

The battery balancing method according to embodiments of the present invention may be performed by a battery management apparatus located in a battery system.

The battery management apparatus may collect state information of batteries (S310). Here, the state information may include one or more of a charge state value, a temperature, and an SOH for each of the batteries.

In the present invention, the charge state value means a value indicating charge status of the battery, and may include one or more of an SOC value, a voltage value, and an open circuit voltage (OCV) value of the battery.

The battery management apparatus may determine whether a charge state value of the battery system falls within a predefined charge state range based on the charge state values of the batteries (S320). Here, the battery management apparatus may determine whether the charge state values of one or more of the batteries belong to a predefined low charge state range or a high charge state range.

The low charge state range may be defined as a range that is lower than or equal to a predefined first charge state value and the high charge state range may be defined as a range that is higher than or equal to a predefined second charge state value. For example, a low charge state range may be defined as a range in which the SOC is 35% or less and a high charge state range may be defined as a range in which the SOC is 95% or more.

In the embodiments, the battery management apparatus may determine that a battery system belongs to the low charge state range if a number of batteries having a charge state value lower than or equal to the first charge state value is a predetermined N or more. For example, if the charge state values of all batteries are 35% or less, the battery management apparatus may determine that the battery system belongs to the low charge state range.

In the embodiments, the battery management apparatus may determine that the battery system belongs to a high charge state range if a number of batteries having a charge state value higher than or equal to the second charge state value is a predetermined M or more. For example, if there is one or more batteries having a charge state value higher than or equal to 95%, the battery management apparatus may determine that the battery system belongs to the high charge state range.

When the battery system belongs to a low charge state range or a high charge state range (Y of S320), the battery management apparatus may determine whether a predefined balancing initiation condition is satisfied (S330). Here, the battery management apparatus may check whether a balancing initiation condition defined in correspondence with a current charge state range is satisfied based on the state information of the batteries.

The balancing initiation condition in the low charge state range may include at least one of a first condition in which a deviation among the SOHs of the batteries is within a predetermined threshold range, a second condition in which temperatures of the batteries are higher than or equal to a predetermined threshold temperature, and a third condition in which idle period of the batteries exceeds a predetermined first period.

For example, the balancing initiation condition in the low charge state range may include a first condition in which deviation among the SOHs of the batteries is within 3%, a second condition in which the temperature of all batteries is 0 degrees Celsius or higher, and a third condition in which idle period of the batteries exceeds 60 minutes. Here, when the current charge state range confirmed in S320 belongs to the low charge state range, the battery management apparatus may check whether the first condition, the second condition, and the third condition are satisfied based on the state information of the batteries.

The balancing initiation condition in the high charge state range may include at least one of a second condition in which the temperature of the batteries is equal to or higher than a predetermied temperature and a fourth condition in which the idle period of the batteries exceeds a second predetermied period. Here, the second period may be defined as a period shorter than the first period.

For example, the balancing initiation condition in the high charge state range may include a second condition in which the temperature of all batteries is 0 degrees Celsius or higher and a fourth condition in which the idle period of the batteries exceeds 10 minutes. Here, if the current charge state range confirmed in S320 belongs to the high charge state range, the battery management apparatus may check whether the second condition and the fourth condition are satisfied based on the state information of the batteries.

Meanwhile, the balancing initiation condition in the low charge state range may further include a condition (a first condition) regarding the balance of SOH, unlike the high charge state range. Accordingly, if there is no or very little SOH deviation among the batteries, the balancing control may be performed in both the low charge state and the high charge state. On the other hand, if the SOH deviation among the batteries is large (for example, if a specific battery is replaced), the balancing control is not performed in the low charge state, but only in the high charge state. If the difference in SOH deviation among the LFP batteries is large, it is difficult to accurately determine charge state values of the batteries in the low charge state range. According to the above embodiment, the problem of reduced accuracy of the balancing control may be solved since the balancing control is performed only in the high charge state range when SOH deviation among the batteries is large.

The battery management apparatus may determine whether to initiate a balancing mode for balancing the batteries based on the determination result of S330.

If it is determined that the balancing initiation condition corresponding to the current charge state range is satisfied (Y of S330), the battery management apparatus may initiate a balancing mode (S340).

If it is determined that the balancing initiation condition is not satisfied (N of S330), the battery management apparatus may return to S310 without initiating the balancing mode.

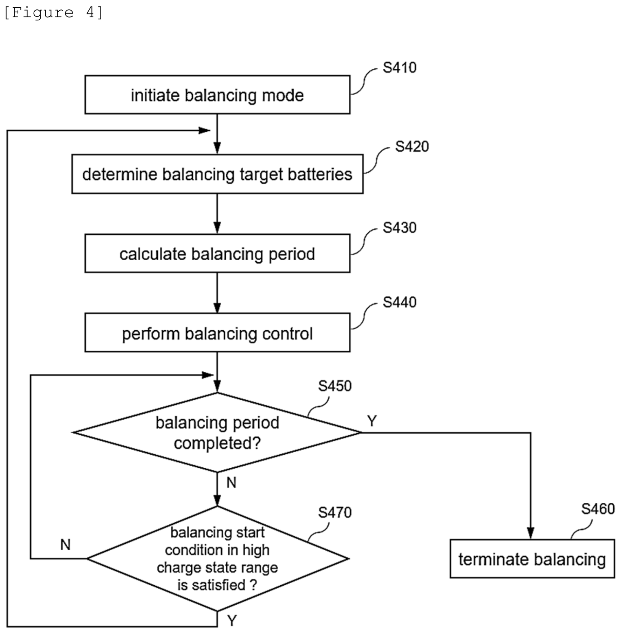

FIG. 4 is an operational flowchart of a battery balancing method after the initiation of the balancing mode according to embodiments of the present invention.

When the balancing mode is initiated (S410), the battery management apparatus may determine one or more balancing target batteries based on difference between the charge state values of the batteries (S420).

Specifically, the battery management apparatus may select at least one battery which satisfies a predefined condition based on difference between the charge state values of the batteries and determine the selected battery as the balancing target battery. Here, the battery management apparatus may determine a battery having a charge state value whose difference from the minimum charge state value is greater than or equal to a predetermined threshold value as a balancing target battery.

The condition for selecting the balancing target battery may be defined corresponding to a current charge state range.

When the balancing mode is initiated in a low charge state range, the battery management apparatus may determine a battery having a charge state value whose difference from the minimum charge state value is greater than or equal to a predetermined first threshold value as a balancing target battery. For example, the battery management apparatus may determine at least one battery having an SOC value that is 5% or more different from the minimum value among the SOC values of the batteries as the balancing target battery.

When the balancing mode is initiated in a high charge state range, the battery management apparatus may determine a battery having a charge state value whose difference from the minimum charge state value is equal to or greater than a predetermined second threshold value as a target battery for balancing. Here, the first threshold value may be determined to a value greater than the second threshold value. For example, the battery management apparatus may determine at least one battery having an SOC value that is 2% or more different from the minimum value among the SOC values of the batteries as the balancing target battery.

Since the second threshold value is determined to a value smaller than the first threshold value, frequency of performing balancing control in the high charge state range may increase and the missetting of target battery for balancing in the low charge state range may be minimized.

When the target battery for balancing is determined, the battery management apparatus may calculate a balancing period (S430).

The battery management apparatus may calculate a balancing period based on capacity of the balancing target battery. Here, the battery management apparatus may set a predetermined ratio of capacity of the balancing target battery as a balancing limit and calculate the balancing period based on the balancing limit and balancing speed. For example, the battery management apparatus may determine 0.1% of the lowest capacity among capacities of the balancing target batteries as balancing limit and calculate the balancing period based on the determined balancing limit and discharge speed (discharge amount per unit time) by a balancing circuit.

The battery management apparatus may perform a predetermined balancing control on the balancing target battery (S440).

The battery management apparatus may perform the balancing control, by controlling a balancing circuit provided in the battery system and reducing the imbalance state among the battery cells. For example, the battery management apparatus may reduce deviation in charge state among the batteries by forcibly discharging the balancing target battery through controlling a passive balancing circuit included in the battery system.

The battery management apparatus may perform the balancing control during the balancing period calculated in S430. Specifically, after the balancing control is initiated, the battery management apparatus may monitor whether the balancing period is completed (S450), and the balancing control may be terminated (termination of balancing mode) (S460), if the balancing period is completed (Y in S450).

The battery management apparatus may check whether a balancing initiation condition in the high charge state range is satisfied based on state information of the batteries (S470) during the process of performing the balancing control (N of S450).

Specifically, the battery management apparatus may monitor whether a charge state value of at least one of the batteries enters the high charge state range during the process of performing the balancing control. If the charge state value of at least one of the batteries enters the high charge state range and the balancing initiation condition in the high charge state range is satisfied, the battery management apparatus may return to S420 and re-determine balancing target battery.

After the balancing mode is initiated in the low charge state, the battery system may be switched to a high charge state by charging. Accordingly, the battery management apparatus may check whether the battery system has entered a high-charge state range during the process of the balancing control is performed and whether the balancing initiation condition (e.g., the second condition and the fourth condition) in the high-charge state range is satisfied, and if the condition is satisfied, the balancing target battery may be updated and then the balancing control may be performed.

The battery management apparatus may monitor whether a charge state value of at least one of the batteries decreases below a predetermined third charge state value during the process of performing the balancing control. If a charge state value of at least one of the batteries decreases below the third charge state value, the battery management apparatus may terminate the balancing control. For example, the battery management apparatus may monitor voltage values of the batteries during the process of performing the balancing control, and when the minimum value among the voltage values decreases below or equal to 2.7 V, the battery management apparatus may terminate balancing control.

After the balancing control is terminated, the battery management apparatus may monitor whether a charge state value of at least one of the batteries increases above or equal to a predetermined fourth charge state value. If a charge state value of at least one of the batteries increases above or equal to the fourth charge state, the battery management apparatus may release the suspension of the balancing control and resume the balancing control. For example, when the minimum value among voltage values has increased to more than 3.22 V after the balancing control is terminated, the battery management apparatus may release the suspension of the balancing control and resume the balancing control.

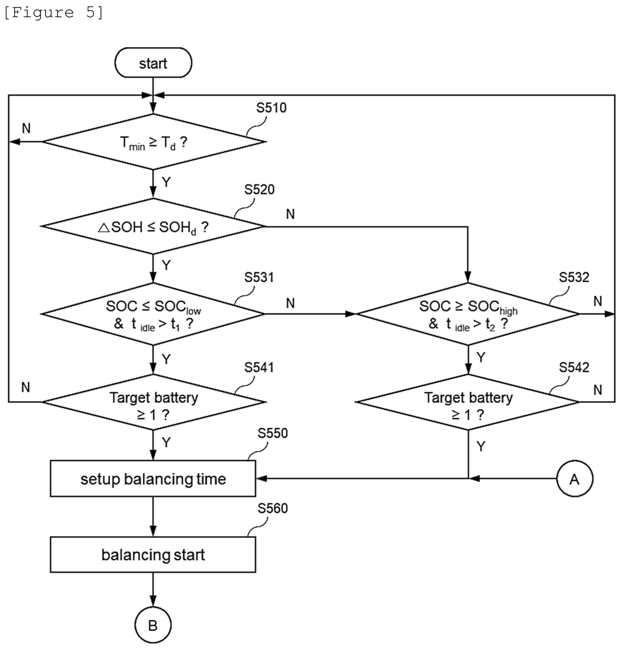

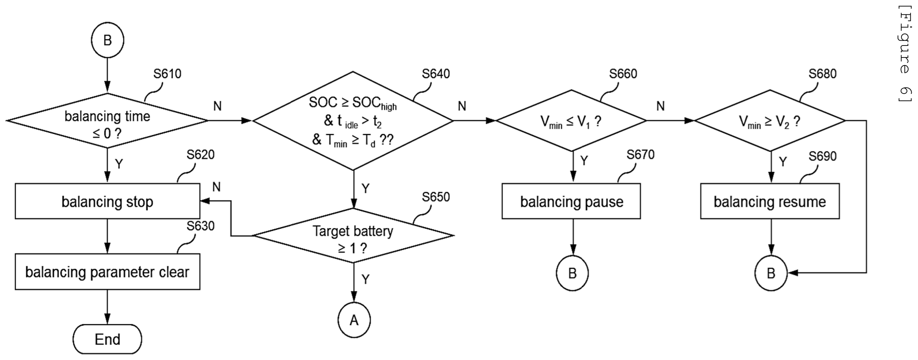

FIGS. 5 and 6 are operational flowcharts of a battery balancing method according to another embodiment of the present invention. In more detail, FIGS. 5 and 6 are implementation examples of the battery balancing method illustrated in FIGS. 3 and 4.

First, referring to FIG. 5, the battery management apparatus may collect state information of batteries. Here, the state information may include a charge state value, a temperature, and an SOH for each battery.

The battery management apparatus may check whether temperatures of the batteries are higher than or equal to a predetermined threshold temperature (Td) (whether the second condition is satisfied) (S510).

If the temperatures of all batteries are higher than or equal to the threshold temperature (Td) (Y of S510), the battery management apparatus may check whether deviation among the SOHs of the batteries is within a predetermined threshold range (SOHd) (whether the first condition is satisfied) (S520).

If the deviation among the SOHs of the batteries is within a predetermined threshold range (SOHd) (Y in S520), the battery management apparatus may check whether the battery system currently belongs to a low charge state range and whether the idle period of the batteries exceeds a predetermined first period (t1) (whether the third condition is satisfied) (S531). Here, if the battery system belongs to a low charge state range and the idle period exceeds the first period (Y in S531), the battery management apparatus may determine the corresponding battery as a balancing target battery (S541). In more details, the battery management apparatus may determine a battery having a charge state value whose difference from the minimum charge state value is equal to or greater than a predetermined first threshold value as a balancing target battery.

If the battery system does not belong to a low charge state range or if the idle period is less than or equal to the first period (N of S531), the battery management apparatus may check whether the battery system currently belongs to a high charge state range and whether the idle period of the batteries exceeds the predetermined second period (t2) (whether the fourth condition is satisfied) (S532). Meanwhile, if the deviation among the SOHs of the batteries exceeds the predetermined threshold range (SOHd) (N of S520), the battery management apparatus may perform S532. Here, if the battery system belongs to a high charge state range and the idle period exceeds the second period (Y of S532), the battery management apparatus may determine the balancing target battery (S542). Specifically, the battery management apparatus may determine a battery having a charge state value whose difference from the minimum charge state value is greater than or equal to the predetermined second threshold value as a balancing target battery. Here, the first threshold value may be determined to a value greater than the second threshold value.

If there is one or more batteries to be balanced (Y of S541, Y of S542), the battery management apparatus may determine a balancing period (S550). Here, the battery management apparatus may set a predetermined ratio of the capacity of balancing target battery as a balancing limit and calculate the balancing period based on the balancing limit and balancing speed.

The battery management apparatus may initiate balancing control for balancing target battery (S560). For example, the battery management apparatus may control a passive balancing circuit included in the battery system to forcibly discharge the balancing target battery, thereby reducing the deviation in charge state among the batteries.

Next, referring to FIG. 6, when the balancing control is initiated, the battery management apparatus may monitor whether the balancing period is completed (S610).

When the balancing period is completed (Y of S610), the battery management apparatus may terminate the balancing control (terminate the balancing mode) (S620) and initialize parameters related to the balancing control (S630).

During a process of performing the balancing control (N of S610), the battery management apparatus may check whether the balancing initiation condition in the high charge state range is satisfied based on the state information of the batteries (S640).

If the battery system enters a high charge state range and the balancing initiation condition in the high charge state range is satisfied (Y of S640), the battery management apparatus may re-determine balancing target battery (S650).

If there is one or more balancing target batteries (Y of S650), the battery management apparatus may determine a balancing period for the re-determined balancing target battery (S550) and initiate the balancing control (S560).

If the balancing initiation condition in the high charge state range is not satisfied (N of S640), the battery management apparatus may check whether the minimum value among the voltage values of the batteries decreases below or equal to a set value (V1; a third charge state value) (S660). Here, if the minimum value decreases below or equal to the set value (Y of S660), the battery management apparatus may terminate the balancing control (S670).

If the minimum value does not decrease below or equal to the third charge state value (N of S660), the battery management apparatus may check whether the minimum value among voltage values of the batteries increases above or equal to a set value (V2; fourth charge state value) (S680). Here, if the minimum value increases above or equal to the set value, the battery management apparatus may release the suspension of the balancing control and resume the balancing control (S690).

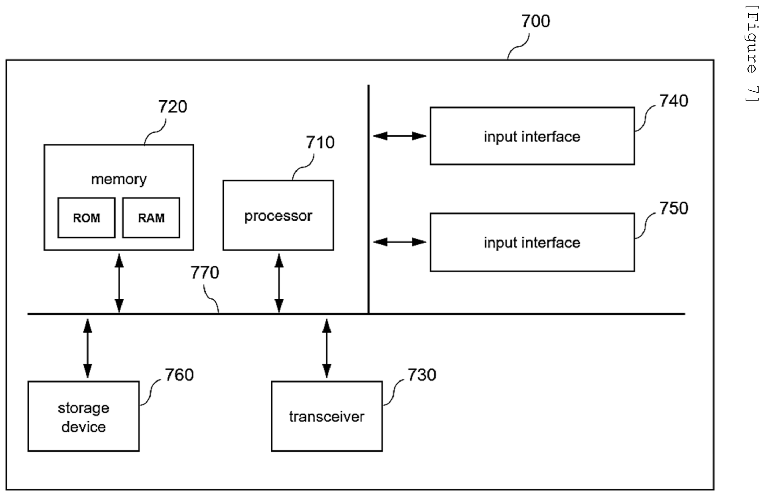

FIG. 7 is a block diagram of a battery management apparatus according to embodiments of the present invention.

The battery management apparatus 700 according to embodiments of the present invention may be located in a battery system including a plurality of batteries, and manage and control the batteries.

The battery management apparatus 700 can be a BMS located inside the battery system or included in the BMS for implementation.

The battery management apparatus 700 may include at least one processor 710, a memory 720 that stores at least one instruction executed by the processor, and a transceiver 730 connected to a network to perform communication.

The at least one instruction may include: an instruction to collect state information including charge state values of the batteries; an instruction to determine whether a charge state value of at least one of the batteries falls within a predetermined low charge state range or a high charge state range; an instruction to determine whether a balancing initiation condition defined in correspondence with a current charge state range is satisfied based on the state information of the batteries; and an instruction to determine whether to initiate a balancing mode for balancing the batteries based on the determination result.

The low charge state range may be defined as a range lower than or equal to a predetermined first charge state value, and the high charge state range is defined as a range higher than or equal to a predetermined second charge state value.

The balancing initiation condition in the low charge state range may include at least one of a first condition in which the deviation among SOHs (State of Health) of the batteries is within a predetermined threshold range, a second condition in which temperature of the batteries is higher than or equal to a predetermined threshold temperature, and a third condition in which an idle period of the batteries exceeds a predetermined first period.

The balancing initiation condition in the high charge state range may include at least one of a second condition in which the temperature of the batteries is higher than or equal to a predetermined threshold temperature and a fourth condition in which an idle period of the batteries exceeds a predetermined second period.

The at least one instruction may further include an instruction to determining balancing target battery based on the difference between the charge state values of the batteries, if the balancing mode is initiated; and an instruction to perform a predetermined balancing control on the balancing target battery.

The instruction to determine the balancing target battery may include an instruction to, when the balancing mode is initiated in the low charge state range, determine at least one battery having a charge state value whose difference from the minimum charge state value is equal to or greater than a predetermined first threshold value as the balancing target battery; and an instruction to, when the balancing mode is initiated in the high charge state range, determine at least one battery having a charge state value whose difference from the minimum charge state value is equal to or greater than a predetermined second threshold value as the balancing target battery,

Here, the first threshold value may be determined to a value greater than the second threshold value.

The instruction to perform the predetermined balancing control may include an instruction to calculate a balancing period based on capacity of the balancing target battery; and an instruction to perform balancing control during the balancing period.

The instruction to perform the predetermined balancing control may include an instruction to monitor whether a charge state value of one or more of the batteries, during process of performing the balancing control, enters the high charge state range.

The instruction to perform the predetermined balancing control may include an instruction to re-determine balancing target battery if the charge state value of one or more of the batteries enters the high charge state range and the balancing initiation condition in the high charge state range is satisfied.

The instruction to perform the predetermined balancing control may include an instruction to monitor whether the charge state value of one or more of the batteries decreases below or equal to a predetermined third charge state value during a process of performing the balancing control; and an instruction to stop the balancing control if the charge state value of one or more of the batteries decreases below or equal to the third charge state value.

The battery management apparatus 700 may further include an input interface 740, an output interface 750, a storage device 760, and the like. Respective components included in the battery management system 700 may be connected by a bus 770 to communicate with each other.

Here, the processor 710 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery management apparatus located in a battery system including a plurality of batteries, the apparatus comprising:
at least one processor; and
a memory configured to store at least one instruction executed by the at least one processor,
wherein the at least one instruction includes:
an instruction to collect state information including charge state values of the batteries;
an instruction to determine whether a charge state value of at least one of the batteries falls within a predetermined low charge state range or a high charge state range;
an instruction to determine whether a balancing initiation condition defined in correspondence with a current charge state range is satisfied based on the state information of the batteries; and
an instruction to determine whether to initiate a balancing mode for balancing the batteries based on the determination result.

2. The apparatus of claim 1, wherein the low charge state range is defined as a range lower than or equal to a predetermined first charge state value, and
wherein the high charge state range is defined as a range higher than or equal to a predetermined second charge state value.

3. The apparatus of claim 1, wherein the balancing initiation condition in the low charge state range includes:
at least one of a first condition in which the deviation among SOHs (State of Health) of the batteries is within a predetermined threshold range, a second condition in which temperature of the batteries is higher than or equal to a predetermined threshold temperature, and a third condition in which an idle period of the batteries exceeds a predetermined first period.

4. The apparatus of claim 1, wherein the balancing initiation condition in the high charge state range includes:
at least one of a second condition in which the temperature of the batteries is higher than or equal to a predetermined threshold temperature and a fourth condition in which an idle period of the batteries exceeds a predetermined second period.

5. The apparatus of claim 1, wherein the at least one instruction further includes:
an instruction to determining balancing target battery based on the difference between the charge state values of the batteries, if the balancing mode is initiated; and
an instruction to perform a predetermined balancing control on the balancing target battery.

6. The apparatus of claim 5, wherein the instruction to determine the balancing target battery includes:
an instruction to, when the balancing mode is initiated in the low charge state range, determine at least one battery having a charge state value whose difference from the minimum charge state value is equal to or greater than a predetermined first threshold value as the balancing target battery; and
an instruction to, when the balancing mode is initiated in the high charge state range, determine at least one battery having a charge state value whose difference from the minimum charge state value is equal to or greater than a predetermined second threshold value as the balancing target battery,
wherein the first threshold value is determined to a value greater than the second threshold value.

7. The apparatus of claim 5, wherein the instruction to perform the predetermined balancing control includes:
an instruction to calculate a balancing period based on capacity of the balancing target battery; and
an instruction to perform balancing control during the balancing period.

8. The apparatus of claim 5, wherein the instruction to perform the predetermined balancing control includes:
an instruction to monitor whether a charge state value of one or more of the batteries, during process of performing the balancing control, enters the high charge state range.

9. The apparatus of claim 8, wherein the instruction to perform the predetermined balancing control includes:
an instruction to re-determine balancing target battery if the charge state value of one or more of the batteries enters the high charge state range and the balancing initiation condition in the high charge state range is satisfied.

10. The apparatus of claim 5, wherein the instruction to perform the predetermined balancing control includes:
an instruction to monitor whether the charge state value of one or more of the batteries decreases below or equal to a predetermined third charge state value during a process of performing the balancing control; and
an instruction to terminate the balancing control if the charge state value of one or more of the batteries decreases below or equal to the third charge state value.

11. A battery balancing method to be performed by a battery management apparatus for managing plurality of batteries, the method comprising:
collecting state information including charge state values of the batteries;
determining whether a charge state value of at least one of the batteries falls within a predetermined low charge state range or a high charge state range;
determining whether a balancing initiation condition defined in correspondence with a current charge state range is satisfied based on the state information of the batteries; and
determining whether to initiate a balancing mode for balancing the batteries based on the determination result.

12. The method of claim 11, wherein the low charge state range is defined as a range lower than or equal to a predetermined first charge state value, and
wherein the high charge state range is defined as a range higher than or equal to a predetermined second charge state value.

13. The method of claim 11, wherein the balancing initiation condition in the low charge state range includes:
at least one of a first condition in which the deviation among SOHs (State of Health) of the batteries is within a predetermined threshold range, a second condition in which temperature of the batteries is higher than or equal to a predetermined threshold temperature, and a third condition in which an idle period of the batteries exceeds a predetermined first period.

14. The method of claim 11, wherein the balancing initiation condition in the high charge state range includes:
at least one of a second condition in which the temperature of the batteries is higher than or equal to a predetermined threshold temperature and a fourth condition in which an idle period of the batteries exceeds a predetermined second period.

15. The method of claim 11, wherein further comprising:
determining balancing target battery based on the difference between the charge state values of the batteries, if the balancing mode is initiated; and
performing a predetermined balancing control on the balancing target battery.

16. The method of claim 15, wherein the determining the balancing target battery includes:
when the balancing mode is initiated in the low charge state range, determining at least one battery having a charge state value whose difference from the minimum charge state value is equal to or greater than a predetermined first threshold value as the balancing target battery; and
when the balancing mode is initiated in the high charge state range, determining at least one battery having a charge state value whose difference from the minimum charge state value is equal to or greater than a predetermined second threshold value as the balancing target battery,
wherein the first threshold value is determined to a value greater than the second threshold value.

17. The method of claim 15, wherein the performing the predetermined balancing control includes:
calculating a balancing period based on capacity of the balancing target battery; and
performing balancing control during the balancing period.

18. The method of claim 15, wherein the performing the predetermined balancing control includes:
monitoring whether a charge state value of one or more of the batteries, during process of performing the balancing control, enters the high charge state range.

19. The method of claim 18, wherein the performing the predetermined balancing control includes:
re-determining balancing target battery if the charge state value of one or more of the batteries enters the high charge state range and the balancing initiation condition in the high charge state range is satisfied.

20. The method of claim 15, wherein the performing the predetermined balancing control includes:
monitoring whether the charge state value of one or more of the batteries decreases below or equal to a predetermined third charge state value during a process of performing the balancing control; and
terminating the balancing control if the charge state value of one or more of the batteries decreases below or equal to the third charge state value.

21. A battery system comprising:
a plurality of batteries; and
a battery management apparatus configured to collect state information of the batteries and to manage and control the batteries based on the collected state information,
wherein the battery management apparatus is configured to determine whether a charge state value of at least one of the batteries falls within a predetermined low charge state range or a high charge state range, to determine whether a balancing initiation condition defined in correspondence with a current charge state range is satisfied based on the state information of the batteries, and to determine whether to initiate a balancing mode for balancing the batteries based on the determination result.
